# EUROPEAN PATENT APPLICATION

(11) **EP 2 728 981 A2**
(43) Date of publication of application: **07.05.2014**
(21) Application number: 13163000.6
(22) Date of filing: 09.04.2013
(51) Int. Cl.: H05K 3/36, H05K 3/32

(54) **Connecting structure between circuit boards and battery pack having the same**

(30) Priority: 30.10.2012 US 201261720097 P; 22.02.2013 US 201313774768
(71) Applicant: Samsung SDI Co., Ltd., Yongin-si, Gyeonggi-do (KR)
(72) Inventor: Shin, Kyungjae, Yongin-si (Gyeonggi-do) (KR); Kim, Kiwoong, Yongin-si (Gyeonggi-do) (KR)
(74) Representative: Santarelli

(57) **Abstract**

Connecting structure between circuit boards, comprising a first circuit board (200) having at least one first circuit pattern, a second circuit board (300) having at least one second circuit pattern (320) electrically connected to the first circuit pattern (220) of the first circuit board (200), and a conductive connecting member (400) interposed between the first circuit pattern (220) and the second circuit pattern (320), wherein the first circuit pattern (220) has a first surface making a contact with the conductive connecting member (400) and a second surface attached to a first base insulating layer (210) in the first circuit board (200), and at least one hole (211) is formed in a region of the first base insulating layer (210) corresponding to the first circuit pattern (220), said at least one hole being closed at one end by the second surface of the first circuit pattern (220) and opened to the exterior at the opposite end.

A battery pack having such a structure and a method for making it are also provided.

## Description

### TECHNICAL FIELD

Embodiments relate to a connecting structure between circuit boards and a battery pack having the same.

### BACKGROUND ART

Generally, a battery pack may include a battery cell, a rigid printed circuit board and a flexible printed circuit board. Onto the rigid printed circuit board, the flexible printed circuit board may be soldered by means of soldering iron, a hot bar, etc.

For example, solder may be coated on the circuit patterns of a rigid printed circuit board, and the circuit patterns of a flexible printed circuit board may be attached onto the solder. Then, a hot bar pressures and heats the flexible printed circuit board toward the rigid printed circuit board. The solder may reflow to make an electric connection between the circuit patterns of the rigid printed circuit board and the circuit patterns of the flexible printed circuit board. Of course, the solder of a liquid state may be cured to a solid state in a following cooling process.

However, according to the common soldering method, the circuit patterns of the flexible printed circuit board may be extruded and extended outward in a cantilever manner. In this case, the circuit patterns may make a direct contact with the hot bar and the circuit patterns may be damaged easily. In addition, the liquid state solder may make a contact with the hot bar, and a removing process of the solder from the hot bar may be required.

In addition, the hot bar may make a direct contact with the circuit patterns of the flexible printed circuit board and the solder. In this case, the solder of the liquid state may make a contact with the hot bar, and an electric short of a plurality of the circuit patterns may be frequently generated due to the solder of the liquid state.

Further, since the circuit patterns of the flexible printed circuit board may be extruded and extended outward to a certain length, a process of coating the circuit patterns with an insulating epoxy material may be additionally conducted to protect the circuit patterns from external environment.

### DESCRIPTION OF THE INVENTION

### TECHNICAL PROBLEM

According to exemplary embodiments, a connecting structure between circuit boards, in which a hot bar does not make a direct contact with a circuit pattern of a flexible printed circuit board while soldering the flexible printed circuit board onto a rigid printed circuit board, thereby preventing the damage of the circuit pattern, and restraining an electric short between a plurality of the circuit patterns by solder, and a battery pack having the same are provided.

According to exemplary embodiments, a connecting structure between circuit boards, in which circuit patterns of a flexible printed circuit board making a contact with a hot bar is covered with an insulating layer, thereby improving the strength of the circuit patterns and possibly omitting an epoxy coating process, and a battery pack having the same are provided.

According to exemplary embodiments, a connecting structure between circuit boards, in which at least one hole is formed in an insulating layer making a contact with a hot bar, thereby accomplishing soldering without increasing the temperature of the hot bar and increasing the lifetime of the hot bar, and a battery pack having the same are provided.

A method for connecting a first circuit board and a second circuit board of such a connecting structure is also provided.

### TECHNICAL SOLUTION

According to exemplary embodiments, a connecting structure between circuit boards and a battery pack having the same are provided. The connecting structure between circuit boards comprises:
a first circuit board having at least one first circuit pattern;
a second circuit board having at least one second circuit pattern electrically connected to the first circuit pattern of the first circuit board ; and
a conductive connecting member interposed between the first circuit pattern and the second circuit pattern, wherein
the first circuit pattern has a first surface making a contact with the conductive connecting member and a second surface attached to a first base insulating layer in the first circuit board, and
at least one hole is formed in a region of the first base insulating layer corresponding to the first circuit pattern, said at least one hole being closed at one end by the second surface of the first circuit pattern and opened to the exterior at the opposite end. The width of the hole may be smaller than the width of the corresponding first circuit pattern.

The first circuit board may comprise a plurality of holes aligned along a longitudinal direction of each of the first circuit patterns, in one or more rows.The hole may have a long hole shape positioned perpendicularly or parallel to the longitudinal direction of the first circuit pattern.

The width of the first circuit pattern may be smaller than the width of the second circuit pattern.

The first circuit board may comprise a cover insulating layer covering the first circuit pattern and the first base insulating layer, except in the region where the first surface makes a contact with the conductive connecting member.

The cover insulating layer of the first circuit board may not cover the second circuit board.

The melting point or glass transition temperature of the first base insulating layer may be higher than the melting point or the glass transition temperature of the conductive connecting member.

The first base insulating layer or cover insulating layer may be formed by using polyimide and/or polyethylene terephthalate (PET).

The conductive connecting member may be solder, an anisotropic conductive film (ACF) or a Z-axis film (ZAF).

The first circuit board may be a flexible printed circuit board and the second circuit board may be a rigid printed circuit board.

The at least one hole may extend vertically from the second surface to an external surface of the first base insulating layer, facing the second surface.

The battery pack may comprise a plurality of battery cells, pack terminals and a connecting structure as defined above, for connecting the battery cells to the pack terminals.

A method for connecting a first circuit board and a second circuit board of connecting structure as defined above is also provided. It comprises the successive steps of:
- mounting the first circuit board on the second circuit board, while aligning the positions of the first circuit pattern and the second circuit pattern ;
- pressing on and heating the first circuit board with a hot bar, at a temperature from 150°C to 300°C ; and
- separating the hot bar from the first circuit board.

### ADVANTAGEOUS EFFECT

According to exemplary embodiments, a connecting structure between circuit boards, in which a hot bar does not make a direct contact with a circuit pattern of a flexible printed circuit board while soldering the flexible printed circuit board onto a rigid printed circuit board, thereby preventing the damage of the circuit pattern, and restraining an electric short between a plurality of circuit patterns by solder, and a battery pack having the same may be provided.

According to exemplary embodiments, a connecting structure between circuit boards, in which the circuit patterns of a flexible printed circuit board making a contact with a hot bar is covered with an insulating layer, thereby improving the strength of the circuit patterns and possibly omitting an epoxy coating process, and a battery pack having the same may be provided.

According to exemplary embodiments, a connecting structure between circuit boards, in which at least one hole is formed in an insulating layer making a contact with a hot bar, thereby accomplishing soldering without increasing the temperature of the hot bar and increasing the lifetime of the hot bar, and a battery pack having the same may be provided.

### BRIEF DESCRIPTION OF THE DRAWINGS

FIG. 1A illustrates a circuit diagram of a common battery pack, FIG. 1B illustrates a schematic diagram of a common battery pack, and FIG. 1C illustrates a plan view of a connecting structure between circuit boards according to an embodiment.
FIG. 2A illustrates a plan view of a circuit board according to an embodiment, FIG. 2B illustrates a bottom view, FIG. 2C illustrates a cross-sectional view of FIG. 2A cut along a line 2c-2c, and FIG. 2D illustrates a cross-sectional view of FIG. 2A cut along a line 2d-2d.
FIG. 3A illustrates a partially enlarged plan view on the connecting structure between circuit boards according to an embodiment, FIG. 3B illustrates a cross-sectional view of FIG. 3A cut along a line 3b-3b, and FIG. 3C illustrates a cross-sectional view of FIG. 3A cut along a line 3c-3c.
FIGS. 4A and 4B illustrate cross-sectional views of the connecting structure between circuit boards according to another embodiment.
FIGS. 5 to 8 illustrate partially enlarged plan views on the connecting structure portion between circuit boards according to another embodiment.
FIGS. 9A and 9B illustrate a schematic diagram for explaining a connecting method of circuit boards according to an embodiment.

### DETAILED DESCRIPTION FOR CARRYING OUT THE INVENTION

Example embodiments will now be described more fully hereinafter with reference to the accompanying drawings.

The present inventive concept may, however, be embodied in different forms and should not be construed as limited to the embodiments set forth herein. Rather, these embodiments are provided so that this disclosure will be thorough and complete, and will fully convey the scope of the invention to those skilled in the art.

In the drawings, the sizes and relative sizes of layers may be exaggerated for the convenience of description and clarity. Like numerals refer to like elements throughout. As used herein, the term "and/or" includes any and all combinations of one or more of the associated listed items.

The terminology used herein is for the purpose of describing particular example embodiments only and is not intended to be limiting of the present inventive concept. As used herein, the singular forms are intended to include the plural forms as well, unless the context clearly indicates otherwise. It will be further understood that the terms "comprise" and/or "comprising," when used in this specification, specify the presence of stated features, integers, steps, operations, elements, and/or groups, but do not preclude the presence or addition of one or more other features, integers, steps, operations, elements, components, and/or groups thereof.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present inventive concept.

Moreover, each feature of an embodiment can be implemented in another embodiment, unless the context clearly indicates otherwise.

The connecting structure between circuit boards in accordance with exemplary embodiments may be used in a hard disk drive (HDD), a solid state drive (SDD), a camera module, a liquid crystal display (LCD) and a plasma display panel (PDP) as well as a battery pack, which will be described below. Accordingly, exemplary embodiments may not be limited to the use of the battery pack.

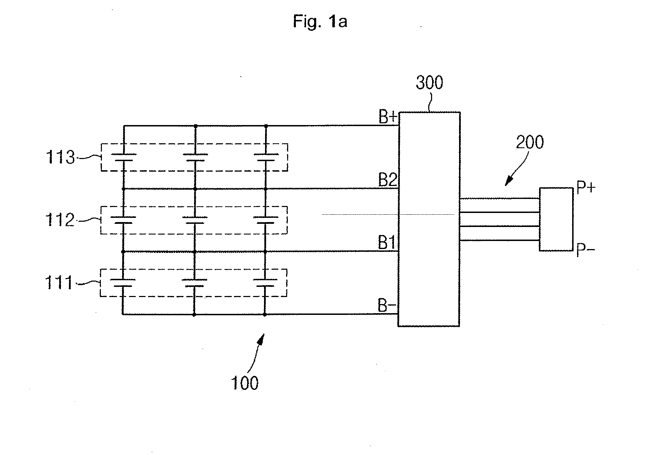

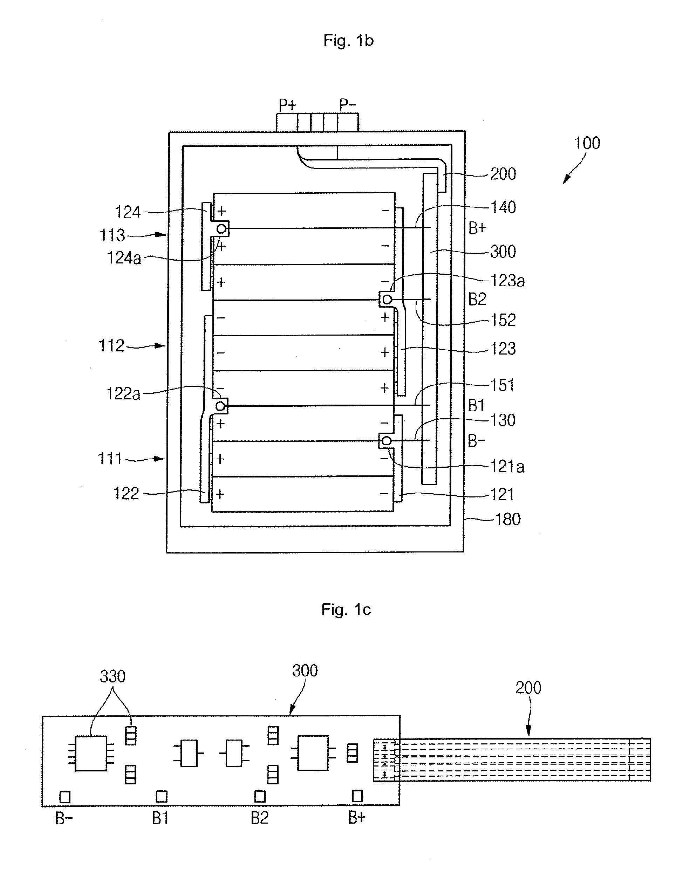

FIG. 1A illustrates a circuit diagram of a common battery pack, FIG. 1B illustrates a schematic diagram of a common battery pack, and FIG. 1C illustrates a plan view of a connecting structure between circuit boards according to an embodiment.

As illustrated in FIGS. 1A to 1C, a battery pack 100 in accordance with exemplary embodiments includes a plurality of battery cells 111, 112 and 113, a plurality of conductive plates 121, 122, 123 and 124 for connecting each of the battery cells 111, 112 and 113, a wire for minimum power supply 130, a wire for maximum power supply 140, a plurality of sensing wires 151 and 152, a rigid printed circuit board 300 and a flexible printed circuit board 200.

The plurality of the battery cells 111, 112 and 113 are connected in series and/or in parallel. Particularly, the plurality of the battery cells 111, 112 and 113 include three of first battery cells 111 connected to each other in parallel, three of second battery cells 112 connected to each other in parallel, and three of third battery cells 113 connected to each other in parallel. In addition, the first battery cell 111, the second battery cell 112 and the third battery cell 113 are connected in series. Though the battery cells 111, 112 and 113 connected by a 3 series 3 parallel (3S3P) manner are illustrated in the drawings, this type is only an illustrative example for assisting understanding of the present inventive concept, however, will not limit the present inventive concept to the connection type.

The conductive plates 121, 122, 123 and 124 connect adjacent battery cells 111, 112 and 113 in series. Particularly, the conductive plates 121, 122, 123 and 124 include a first conductive plate 121, a second conductive plate 122, a third conductive plate 123 and a fourth conductive plate 124. The first conductive plate 121 is connected to a minimum power supply, i.e., to an anode electrode of the first battery cell 111. In other words, the first conductive plate 121 is connected to the three anode electrodes of the battery cell 111 in parallel. The second conductive plate 122 interconnects the first battery cell 111 and the second battery cell 112 in series. Of course, the second conductive plate 122 connects the cathode electrodes of the first battery cell 111 in parallel and at the same time, connects the anode electrodes of the second battery cell 112 in parallel. The third conductive plate 123 interconnects the second battery cell 112 and the third battery cell 113 in series. Of course, the third conductive plate 123 connects the cathode electrodes of the second battery cell 112 in parallel and at the same time, connects the anode electrodes of the third battery cell 113 in parallel. The fourth conductive plate 124 is connected to the maximum power supply, i.e., the cathode electrodes of the third battery cell 113. In other words, the fourth conductive plate 124 is connected to the cathode electrodes of the third battery cell 113 in parallel. Meanwhile, the first to fourth conductive plates 121, 122, 123 and 124 include extrusion taps 121a, 122a, 123a and 124a with a specific length for an easy soldering with a wire in a following process. Of course, the number of the conductive plates 121, 122, 123 and 124 increases dependently on the number of the battery cells 111, 112 and 123 used.

The wire for minimum power supply 130 is soldered to the minimum power supply region of the first battery cell 111. That is, one terminal of the wire for minimum power supply 130 is soldered to the tap 121a of the conductive plate 121.

The wire for maximum power supply 140 is soldered to the maximum power supply region of the third battery cell 113. That is, one terminal of the wire for maximum power supply 140 is soldered to the tap 124a of the fourth conductive plate 124.

Two sensing wires 151 and 152 are provided as in the drawings. For the convenience of the explanation, a first sensing wire 151 and a second sensing wire 152 are differentiated. One terminal of the first sensing wire 151 is soldered to the tap 122a of the second conductive plate 122. In addition, one terminal of the second sensing wire 152 is soldered to the tap 123a of the third conductive plate 123. Similarly, the number of the sensing wires 151 and 152 increases dependently on the numbers of the battery cells and so the conductive plates.

The rigid printed circuit board 300 is disposed at a side (or an upper portion) of the first, second, third battery cells 111, 112 and 113, as illustrated in the drawings. Here, the wire for minimum power supply 130 is connected to the B- terminal, the first sensing wire 151 is connected to the B1 terminal, the second sensing wire 152 is connected to the B2 terminal, and the wire for maximum power supply 140 is connected to the B+ terminal of the rigid printed circuit board 300. In the rigid printed circuit board 300, a plurality of battery protecting elements 330 such as a temperature sensor, a voltage sensor, a current sensor, a charge controlling switch, a discharge controlling switch, a microcomputer, etc. are installed.

The flexible printed circuit board 200 is soldered to one side of the rigid printed circuit board 300. In addition, pack terminals P+ and P- are combined with the terminal portion of the flexible printed circuit board 200. Here, the flexible printed circuit board 200 may bent freely when compared to the rigid printed circuit board 300. Thus, the flexible printed circuit board 200 may bent to a specific direction from the rigid printed circuit board 300 to be combined with the pack terminals P+ and P-. Of course, the pack terminals P+ and P- are connecting portions to an external charger or to an external set. Unexplained reference numeral 180 represents a pack case for installing all the constituting elements described above.

Here, the rigid printed circuit board 300 may be commonly formed by using an epoxy resin and/or a phenol resin as main materials and may include circuit patterns formed on the surface thereof. Since the epoxy resin and/or the phenol resin are relatively thick, heavy and rigid, the rigid printed circuit board 300 may not be bent well. The basic structure of the rigid printed circuit board 300 is well known to a person in the art, and an explanation thereof will be omitted.

Flexible printed circuit board (FPCB) 200 is also called as flexible wire (FW) or flexible circuitry (FC) and is formed by using polyimide and/or polyethylene terephthalate (PET) as main materials, and circuit patterns are formed on the surface thereof. Polyimide and/or PET are relatively light, thin and flexible, and so, the flexible printed circuit board 200 may be bent well.

Hereinafter, the flexible printed circuit board will be called as a first circuit board, and the rigid printed circuit board will be called as a second circuit board for the convenience of explanation. Of course, the first circuit board includes a first circuit pattern and a first base insulating layer, and the second circuit board includes a second circuit pattern and a second insulating layer.

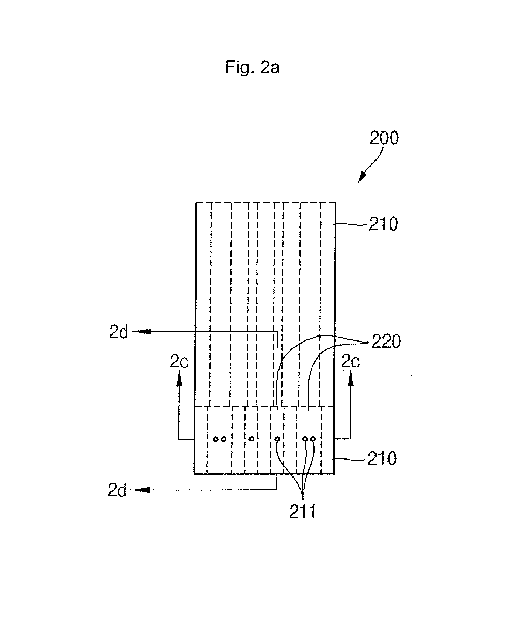

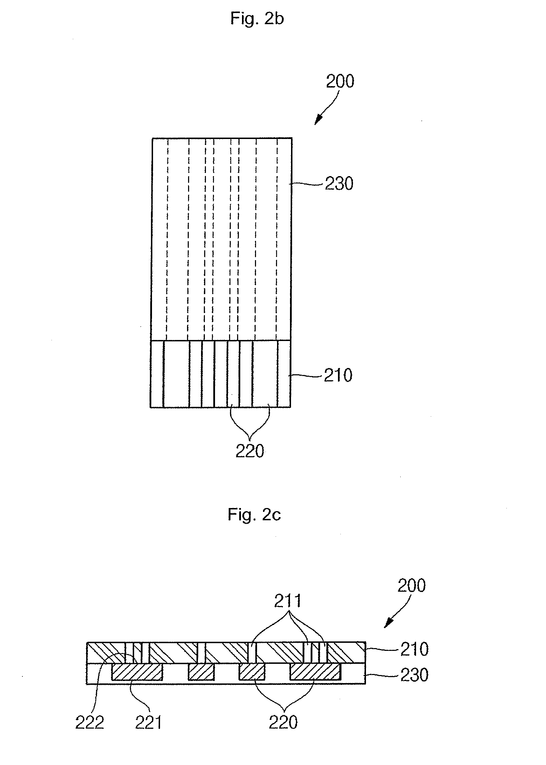

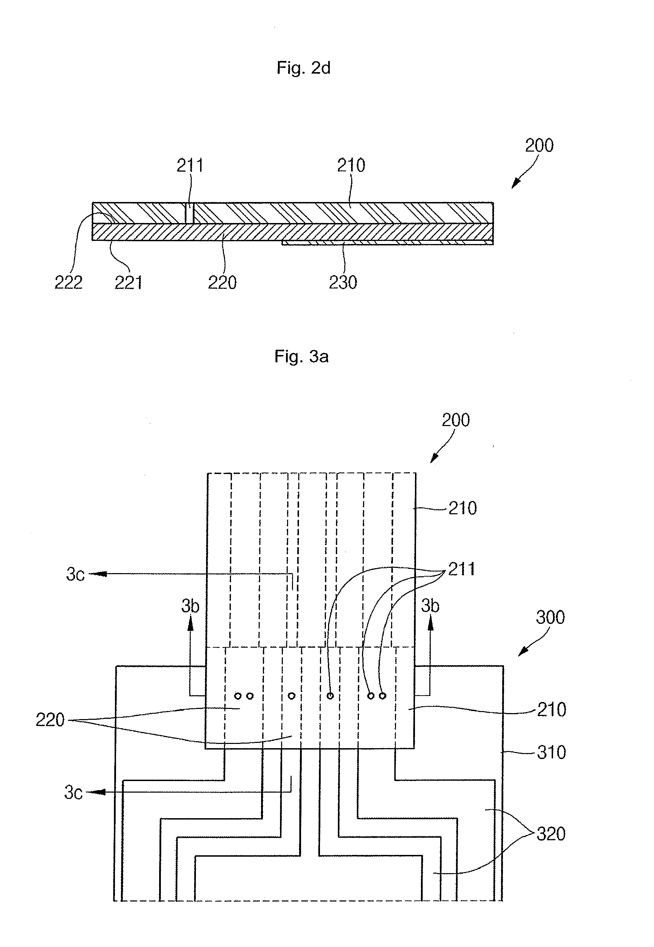

FIG. 2A illustrates a plan view of a circuit board according to an embodiment, FIG. 2B illustrates a bottom view, FIG. 2C illustrates a cross-sectional view of FIG. 2A cut along a line 2c-2c, and FIG. 2D illustrates a cross-sectional view of FIG. 2A cut along a line 2d-2d.

As illustrated in FIGS. 2A to 2D, a first circuit board 200 includes a first base insulating layer 210 having, here, a plurality of vertical holes 211, a first circuit pattern 220 and a first cover insulating layer 230.

The first base insulating layer 210 having the holes 211, has a roughly flat panel shape and a thickness of about 0.5 µm to 500 µm. However, the thickness value is not limited in exemplary embodiments and may be changed according to the surroundings, the bending angle of the first circuit board 200, the required strength of the first circuit board 200, etc. In addition, the first base insulating layer 210 may be formed by using one material selected from polyimide, PET and an equivalent thereof. However, the kinds of the material are not limited to them in exemplary embodiments. The first base insulating layer 210 is required to have good insulating property and a high glass transition temperature (Tg) so as to show a small dimensional deformation at a high temperature, a good heat-resistance and a good flexibility. In addition, the first base insulating layer 210 is required to have a good chemical-resistance and a resistance to moisture. Considering the above conditions, polyimide or PET is appropriate. Particularly, when the first base insulating layer 210 is polyimide, the glass transition temperature (Tg) thereof is greater than or equal to about 300°C to 400°C, and the melting point (Tm) thereof is greater than or equal to about 500°C to 700°C. Accordingly, the polyimide may sufficiently endure at the temperature range for soldering (about 150°C to 300°C) and may show the above described physical and chemical properties.

In addition, the holes 211 formed in the first base insulating layer 210 may be formed to have one of a circular shape, a long hole shape, a quadrangular shape and a polygonal shape. However, the hole shape is not limited to these in exemplary embodiments. The holes 211 function to rapidly disperse the heat of a hot bar 600 to the first circuit pattern 220.

The first circuit pattern 220 is formed on the first base insulating layer 210 and has a thickness of about 30 µm to 100 µm. However, the thickness is not limited to the range in accordance with exemplary embodiments and may be changed according to current, the desired bending angle of the first circuit board 200, the desired strength of the first circuit board 200, etc. The first circuit pattern 220 may be formed directly on the first base insulating layer 210 by one of casting, lamination, sputtering and an equivalent method thereof. However, the method is not limited to the above described methods in exemplary embodiments. The first circuit pattern 220 may be formed on the first base insulating layer 210 by forming an adhesive layer (not illustrated) and then laminating the first circuit pattern 220 on the adhesive layer. The first circuit pattern 220 may be formed by using one selected from copper (Cu), aluminum (Al), gold (Au), silver (Ag), and an equivalent thereof, without limitation.

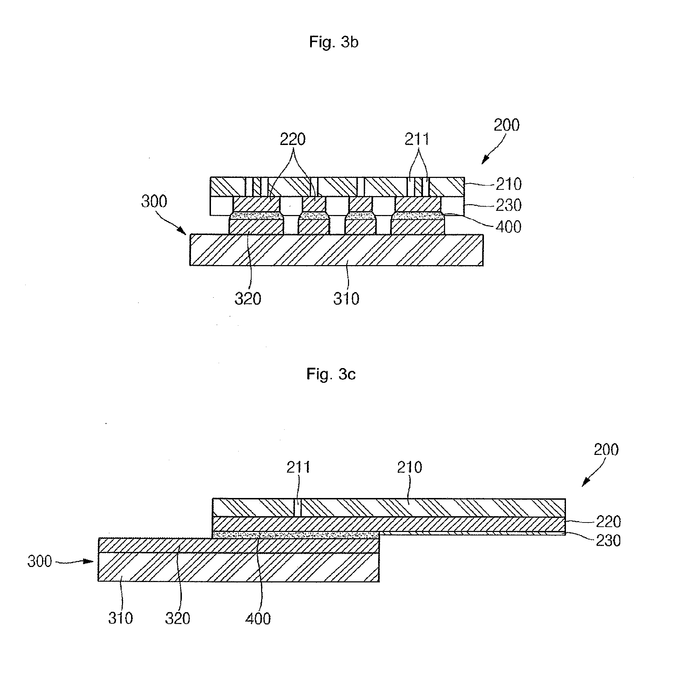

The first circuit pattern 220 includes a first surface 221, making a contact with conductive connecting members 400 and 500 (illustrated from figure 3B), and a second surface 222 facing the first surface 221 and making a contact with the first base insulating layer 210. Accordingly, the second surface 222 of the first circuit pattern 220 is exposed to exterior through the hole 211 formed in the first base insulating layer 210.

The first cover insulating layer 230 covers the first circuit pattern 220 and the first base insulating layer 210, at the same time. Here, a specific region among the first circuit pattern 220 may not be covered with the first cover insulating layer 230, but may be exposed directly to exterior. Particularly, the first surface 221 (i.e. a contacting region with conductive connecting members 400 and 500) and both side faces of the first circuit pattern 220 formed at one terminal of the first circuit board 200 may not be covered with the first cover insulating layer 230 but may be exposed to exterior. The specific region of the first circuit pattern 220, not covered by the first cover insulating layer 230 but exposed to exterior may be defined as a terminal or a lead. The exposed region of the first circuit pattern 220, not covered by the first cover insulating layer 230 may undergo an electroplating process using one among gold (Au), silver (Ag), nickel (Ni), palladium (Pd), an alloy thereof and an equivalent thereof, to prevent the oxidation of the first circuit pattern 220.

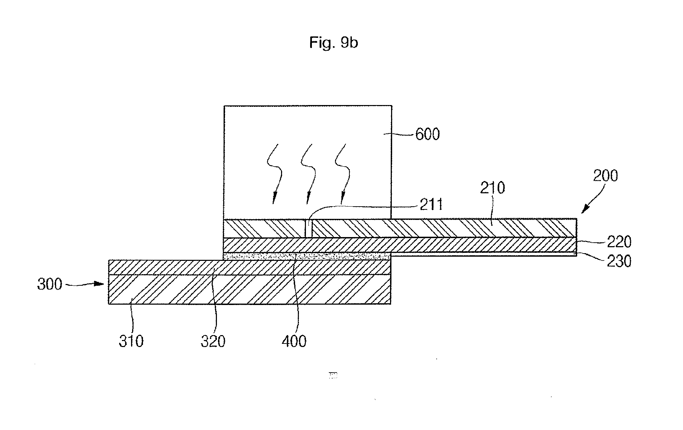

Meanwhile, the first cover insulating layer 230 may be formed by using one selected from polyimide, PET and an equivalent thereof, however, will not be limited to them in exemplary embodiments. Particularly, when the first cover insulating layer 230 is PET, the glass transition temperature (Tg) thereof is greater than or equal to about 70°C to 100°C, and the melting point (Tm) thereof is greater than or equal to about 270°C to 350°C. The hot bar 600 (see figure 9B) may not substantially contact the first cover insulating layer 230. Thus, the first cover insulating layer 230 may not necessarily have a high glass transition temperature and a high melting temperature as the polyimide. The first cover insulating layer 230 also may be called as a coverlayer film.

Here, the first cover insulating layer 230 does not cover the second circuit board, thus reducting the overall height of the connecting structure 100,

Although not illustrated in drawings, an additional reinforcing plate (not illustrated) may be attached on the surface of the first base insulating layer 210 or the first cover insulating layer 230 to reinforce the strength of the first circuit board 200. The reinforcing plate may be formed by using one of polyimide, PET, a glass epoxy and an equivalent thereof, however, will not be limited to these in exemplary embodiments. Of course the flexibility of the first circuit board 200 may be decreased due to the reinforcing plate.

FIG. 3A illustrates a partially enlarged plan view on the connecting structure between circuit boards according to an embodiment, FIG. 3B illustrates a cross-sectional view of FIG. 3A cut along a line 3b-3b, and FIG. 3C illustrates a cross-sectional view of FIG. 3A cut along a line 3c-3c.

As illustrated in FIGS. 3A to 3C, a second circuit board 300 includes a second insulating layer 310, a second circuit pattern 320 formed on the surface of the second insulating layer 310. Here, the first circuit board 200 may be defined as a flexible printed circuit board, and the second circuit board 300 may be defined as a rigid printed circuit board as described above.

The first circuit pattern 220 of the first circuit board 200 is electrically connected with the second circuit pattern 320 of the second circuit board 300 through the conductive connecting member 400. That is, the first surface of the first circuit pattern 220 is electrically connected to the second circuit pattern 320 by the conductive connecting member 400. Of course, the first base insulating layer 210 is positioned at the second surface 222 of the first circuit pattern 220, and at least one hole 211 is formed at a region of the first base insulating layer 210 corresponding to the second surface 222 of the first circuit pattern 220.

At least 1 to 10 holes 211 may be formed for each of the circuit patterns. The width of the hole 211 may also be smaller than the width of the circuit pattern. Accordingly, the conductive connecting member 400 does not flow into the hole(s) 211 even though the conductive connecting member 400 makes a contact with the first base insulating layer 210 through the first circuit pattern 220.

Particularly, when the conductive connecting member 400 is solder, the solder of a liquid state may flow upward along both sides of the first circuit pattern 220 to make a contact with the first base insulating layer 210 during performing a soldering process. However, in accordance with exemplary embodiments as described above, the hole 211 is formed to have a width smaller than the width of the first circuit pattern 220 in a region corresponding to the second surface 222 of the first circuit pattern 220. Thus, the solder flowed upward to the first base insulating layer 210 cannot flow into the hole 211. Accordingly, the heat of the hot bar 600 during performing the soldering process can easily be transferred to the first circuit pattern 220 through the hole 211, however, the solder cannot flow to the hot bar 600.

Meanwhile, the width of the first circuit pattern 220 is preferably smaller than the width of the second circuit pattern 320. In this case, the extra amount of the solder during performing the soldering process remains at the second circuit pattern 320, excluding the first circuit pattern 220, and short between neighboring solders may be prevented.

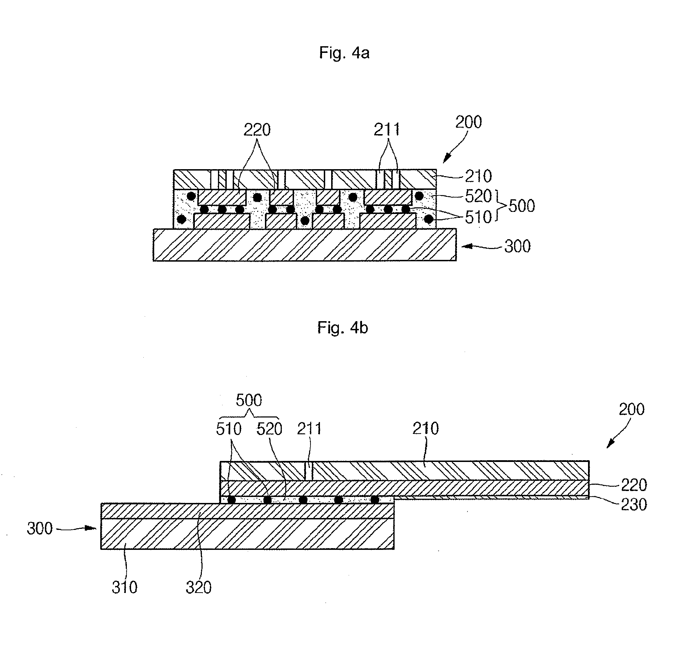

FIGS. 4A and 4B illustrate cross-sectional views of the connecting structure between circuit boards according to another embodiment.

As illustrated in FIGS. 4A and 4B, one selected from anisotropic conductive films (ACF), Z-axis films (ZAF) and an equivalent thereof may be used as the conductive connecting member 500 in accordance with exemplary embodiments. Particularly, when the pitch of the circuit pattern is less than or equal to about 375 µm (about 15 mil), the connection between the first and second circuit substrates using solder may become difficult. That is, when the pitch of the circuit pattern is less than or equal to about 375 µm, short may be easily generated between neighboring solders.

In this case, ACF or ZAF is appropriate as the conductive connecting member 500. The ACF or ZAF has a filled type of conductive particles 510 in an insulating film 520.

First, ACF or ZAF is provided as the conductive connecting member 500 between the first circuit pattern 220 of the first circuit board 200 and the second circuit pattern 320 of the second circuit board 300. Then, the hot bar 600 pressures the first circuit board 200 while heating to laminate the first circuit board 200 on the second circuit board 300. That is, the conductive particles 510 of ACF or ZAF make an electric connection between the first circuit pattern 220 of the first circuit board 200 and the second circuit pattern 320 of the second circuit board 300. In addition, the first circuit board 200 and the second circuit board 300 may be physically connected due to the melting of the insulating film 520. Here, the conductive particles 510 of ACF or ZAF make an interconnection only in z-direction and do not make an interconnection in horizontal x-direction or y-direction.

In this case, the heat of the hot bar 600 positioned on the first circuit board 200 can easily be transferred to the first circuit pattern 220 through the hole 211 formed in the first base insulating layer 210, however, the conductive particles 510 of ACF or ZAF or the insulating film 520 may not be guided into the hole 211.

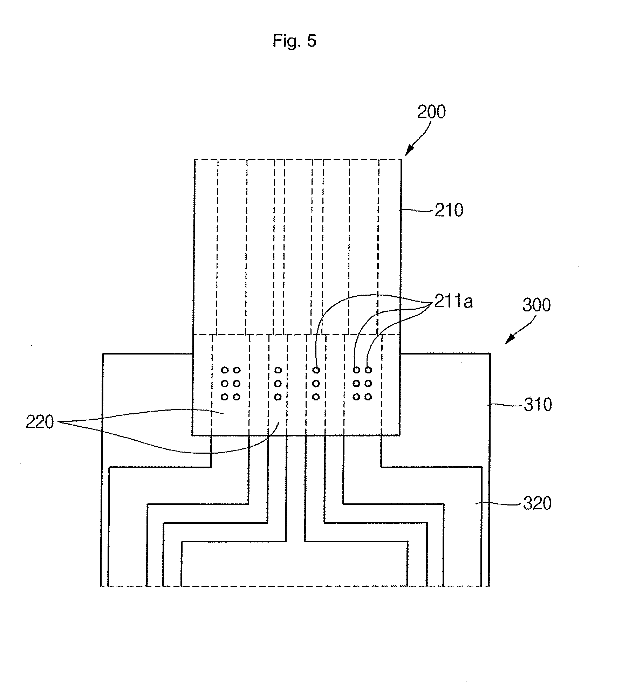

FIGS. 5 to 8 illustrate partially enlarged plan views on the connecting structure portion between circuit boards according to another embodiment.

As illustrated in FIG. 5, the holes 211a formed in the first base insulating layer 210 of the first circuit board 200 may arrange along the longitudinal direction of the first circuit pattern 220. Particularly, one row of the holes 211a may be formed in the first base insulating layer 210 corresponding to one of the first circuit patterns 220 having a relatively small width, while two rows of the holes 211a may be formed in the first base insulating layer 210 corresponding to one of the first circuit pattern 220 having a relatively large width.

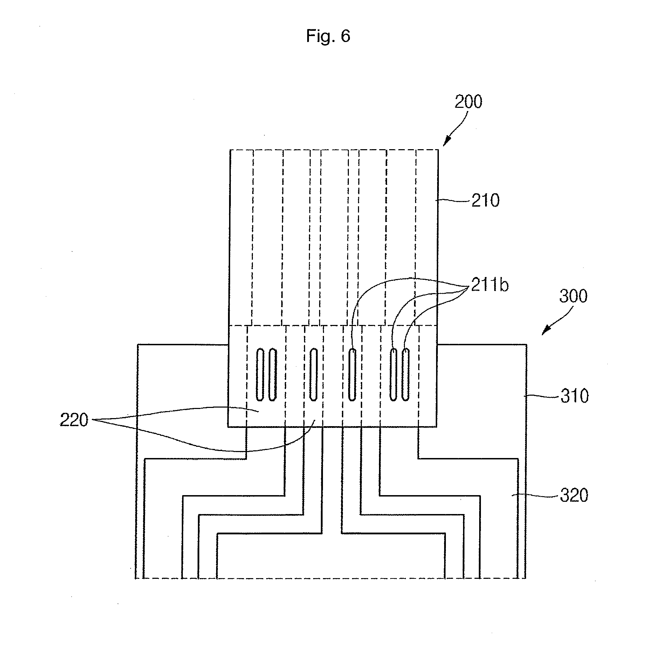

As illustrated in FIG. 6, the holes 211b formed in the first base insulating layer 210 of the first circuit board 200 may have a long hole shape along the longitudinal direction of the first circuit pattern 220. Also, one long hole 211a may be formed in the first base insulating layer 210 corresponding to one of the first circuit patterns 220 having a relatively small width, while two long holes 211a may be formed in the first base insulating layer 210 corresponding to one of the first circuit pattern 220 having a relatively large width.

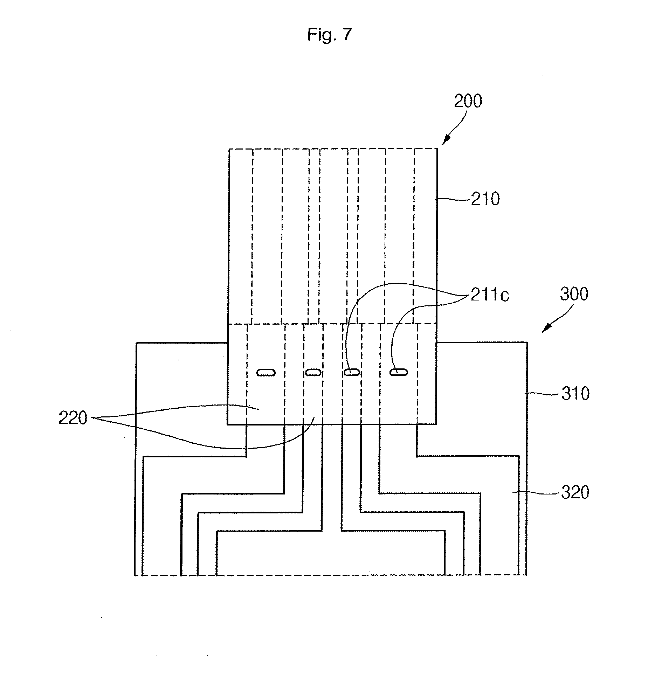

As illustrated in FIG. 7, the holes 211c formed in the first base insulating layer 210 of the first circuit board 200 may have a long hole shape along a transverse direction of the first circuit pattern 220, and about one hole may be formed for one circuit pattern. Of course, the first circuit pattern 220 may be exposed to exterior only through the holes 211c.

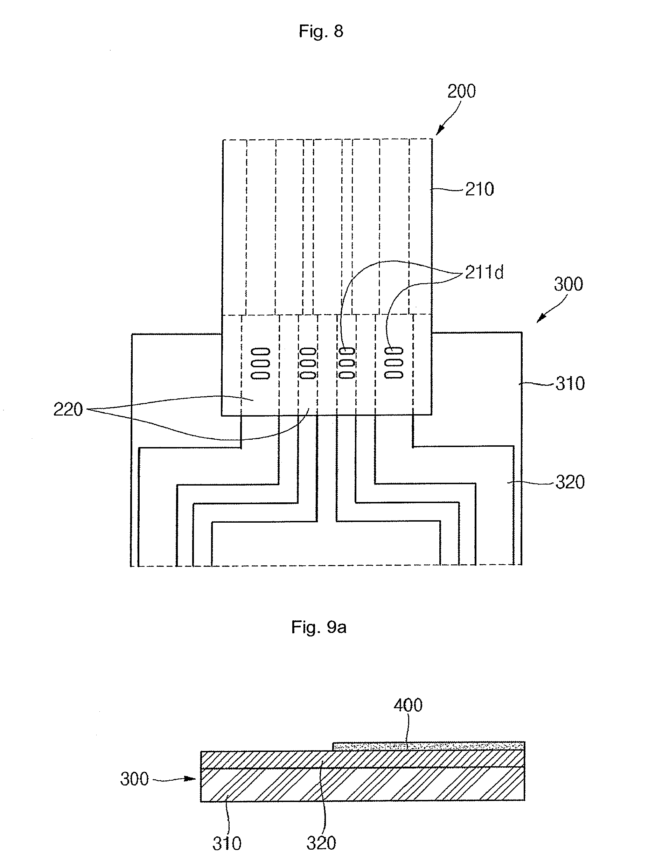

As illustrated in Fig. 8, the holes 211d formed in the first base insulating layer 210 of the first circuit board 200 may be formed in plurality along the longitudinal direction of the first circuit pattern 220 and may have a long hole shape. In FIG. 8, three holes 211d are formed for each of the circuit patterns. In this case, the first circuit pattern 220 may be exposed to the exterior only through the hole 211d.

FIGS. 9A and 9B illustrate a schematic diagram for explaining a connecting method of circuit boards according to an embodiment.

First, as illustrated in FIG. 9A, a second circuit board 300 including a second circuit pattern 320 may be prepared, and a conductive connecting member 400 such as solder may be screen printed on the second circuit pattern 320.

Then, as illustrated in FIG. 9B, a first circuit board 200 including a first circuit pattern 220 is mounted on the second circuit board 300. In this case, the positions of the first circuit pattern 220 of the first circuit board 200 and the second circuit pattern 320 of the second circuit board 300 are aligned.

In this state, the first circuit board 200 is pressured and heated using a hot bar 600 as illustrated in FIG. 9B. Then, the heat from the hot bar 600 is transferred to the first circuit pattern 220 and the conductive connecting member 400 along a first base insulating layer 210 (from its top surface where the hot bar is applied and which is here parallel to surfaces 221 and 222), and efficiently to the first circuit pattern 220 and the solder 400 through the holes 211 formed in the first base insulating layer 210. Here, the temperature provided from the hot bar 600 may be about 150°C to 300°C. Since the glass transition temperature (Tg) of the first base insulating layer 210 constituting the first circuit board 200 is greater than or equal to about 300°C to 400°C, and the melting point (Tm) thereof is greater than or equal to about 500°C to 700°C, any deformation or melting of the first base insulating layer 210 by the heat of the hot bar 600 is not be generated.

Meanwhile, the screen printed solder 400 between the first circuit pattern 220 and the second circuit pattern 320 reflows as a liquid by the temperature provided by the hot bar 600. Since the reflow temperature of the solder 400 is about 150°C to 300°C, solid state solder 400 changes into liquid state solder 400.

Then, the hot bar 600 is separated from the first circuit board 200. The liquid state solder 400 may be cured to electrically and physically combine the first circuit pattern 220 and the second circuit pattern 320 strongly.

Meanwhile, when ACF or ZAF is used as the conductive connecting member 500, the ACF or ZAF may be positioned between the first circuit board 200 and the second circuit board 300. Of course, the positions of the first circuit pattern 220 of the first circuit board 200 and the second circuit pattern 320 of the second circuit board 300 may be aligned. Then, the first circuit board 200 may be pressured and heated by using the hot bar 600. In this case, the heat from the hot bar 600 is transferred to the first circuit pattern 220, and ACF or ZAF 500 along the first base insulating layer 210, and efficiently to the first circuit pattern 220, and ACF or ZAF 500 through the hole(s) 211 formed in the first base insulating layer 210.

In this way, the first circuit pattern 220 and the second circuit pattern 320 are closed to each other in the z-direction, and the conductive particles 510 interposed between the circuit patterns 220 and 320 may electrically interconnect the first circuit pattern 220 and the second circuit pattern 320. Since the conductive particles 510 do not make an electric connection in an x-direction and a y-direction, the neighboring first circuit patterns 220 or second circuit patterns 320 may maintain an electrically insulated state in the horizontal direction.

Accordingly, the hot bar 600 does not make a direct contact with the first circuit pattern 220 of the first circuit board 200 while connecting the first circuit board 200 and the second circuit board 300, damage onto the first circuit pattern 220 may be prevented and electric short between a plurality of the first circuit patterns 220 due to the conductive connecting members 400 and 500 can be restrained.

In addition, since the first circuit pattern 220 of the first circuit board 200 making a contact with the hot bar 600 is covered with the first base insulating layer 210, the strength of the first circuit pattern 220 can be increased, and an epoxy coating process may be omitted.

In addition, since at least one hole of 211, 211a, 211b, 211c and 211d is formed in the first base insulating layer 210 making a contact with the hot bar 600, an electric connection can be accomplished without increasing the temperature of the hot bar 600. Thus, the lifetime of the hot bar 600 can be increased and the damage onto the appearance of the first base insulating layer 210 can be prevented.

The explanation described above is only on example embodiment for accomplishing a circuit board connecting structure and a battery pack having the same according to exemplary embodiments. Accordingly, it will be understood by those of ordinary skill in the art that various changes in form and details may be made without departing from the spirit and scope of the present invention as set forth in the following claims.

## Claims

1. Connecting structure (100) between circuit boards, comprising:
a first circuit board (200) having at least one first circuit pattern (220);
a second circuit board (300) having at least one second circuit pattern (320) electrically connected to the first circuit pattern (220) of the first circuit board (200); and
a conductive connecting member (400 ; 500) interposed between the first circuit pattern (220) and the second circuit pattern (320), wherein
the first circuit pattern (220) has a first surface (221) making a contact with the conductive connecting member (400 ; 500) and a second surface (222) attached to a first base insulating layer (210) in the first circuit board (200), and
at least one hole (211 ; 211a - 211d) is formed in a region of the first base insulating layer (210) corresponding to the first circuit pattern (220), said at least one hole being closed at one end by the second surface (222) of the first circuit pattern (220) and opened to the exterior at the opposite end.

2. Connecting structure according to claim 1, wherein the width of the hole (211 ; 211a - 211d) is smaller than the width of the corresponding first circuit pattern.

3. Connecting structure according to claim 1or 2, wherein the first circuit board (200) comprises a plurality of holes (211a ; 211d) aligned along a longitudinal direction of each of the first circuit patterns, in one or more rows.

4. Connecting structure according to anyone of claims 1 to 3, wherein the hole (211b ; 211c) has a long hole shape positioned perpendicularly or parallely to the longitudinal direction of the first circuit pattern.

5. Connecting structure according to anyone of claims 1 to 4, wherein the width of the first circuit pattern (220) is smaller than the width of the second circuit pattern (320).

6. Connecting structure according to anyone of claims 1 to 5, wherein the first circuit board (200) comprises a cover insulating layer (230) covering the first circuit pattern (220) and the first base insulating layer (210), except in the region where the first surface (221) makes a contact with the conductive connecting member (400 ; 500).

7. Connecting structure according to claim 6, wherein the cover insulating layer (230) of the first circuit board does not cover the second circuit board.

8. Connecting structure according to anyone of claims 1 to 7, wherein the melting point or the glass transition temperature of the first base insulating layer (210) is higher than the melting point or the glass transition temperature of the conductive connecting member (400 ; 500).

9. Connecting structure according to anyone of claims 1 to 8, wherein the first base insulating layer (210) or cover insulating layer (230) is formed by using polyimide and/or polyethylene terephthalate (PET).

10. Connecting structure according to anyone of claims 1 to 9, wherein the conductive connecting member (400 ; 500) is solder, an anisotropic conductive film (ACF) or a Z-axis film (ZAF).

11. Connecting structure according to anyone of claims 1 to 10, wherein the first circuit board (200) is a flexible printed circuit board and the second circuit board (300) is a rigid printed circuit board.

12. Connecting structure according to any one of the preceding claims, wherein the at least one hole extends vertically from the second surface to an external surface of the first base insulating layer, facing the second surface.

13. Battery pack comprising a plurality of battery cells (111 - 113) ; pack terminals (P+ ; P-) and a connecting structure (100) as defined in anyone of claims 1 to 12, for connecting the battery cells to the pack terminals.

14. Method for connecting a first circuit board and a second circuit board of a connecting structure as defined in anyone of claims 1 to 12, comprising the successive steps of :
- mounting the first circuit board on the second circuit board, while aligning the positions of the first circuit pattern and the second circuit pattern ;
- pressing on and heating the first circuit board with a hot bar, at a temperature from 150°C to 300°C ; and
- separating the hot bar from the first circuit board.
